# EUROPÄISCHE PATENTANMELDUNG

(11) **EP 2 302 797 A1**
(43) Veröffentlichungstag der Anmeldung: **30.03.2011**
(21) Anmeldenummer: 09171100.2
(22) Anmeldetag: 23.09.2009
(51) Int. Cl.: H03K 17/691

(54) **Steuerung für ein Halbleiterbauelement**

(71) Anmelder: ABB Schweiz AG, 5400 Baden (CH)
(72) Erfinder: Weber, Florian, 5417 Untersiggenthal (CH)
(74) Vertreter: Berner, Thomas

(57) **Zusammenfassung**

Eine Rückmeldung an eine Sekundärsteuerung 14, beispielsweise über eine Fehlfunktion eines Halbleiterbauelements 18, wird über die gleiche Leitung 20 übertragen, die zur Energieversorgung einer Primärsteuerung 12 des Halbleiterbauelements 18 dient. Eine vorhandene galvanische Entkopplung 28 der Leitung 20 wird auch zur galvanischen Entkopplung der Signalübertragung verwendet.

## Beschreibung

### Technisches Gebiet

Die Erfindung betrifft das Feld der Steuerung von Halbleiterbauelementen, insbesondere Hochleistungshalbleiterbauelementen. Im Speziellen betrifft die Erfindung eine Primärsteuerung für ein Halbleiterbauelement, eine Sekundärsteuerung für das Halbleiterbauelement zur Stromversorgung der Primärsteuerung, eine Steuerung für ein Halbleiterbauelement, die die Primärsteuerung und die Sekundärsteuerung umfasst, die Verwendung einer galvanisch entkoppelten Stromleitung zwischen der Primärsteuerung und der Sekundärsteuerung sowie ein Verfahren zum Steuern des Halbleiterbauelements.

### Stand der Technik

Bei einem typischen Hochleistungshalbleitersystem, beispielsweise einem System, das in der Lage ist, Ströme über 100 A und/oder Spannungen über 300 V zu schalten, wird ein Halbleiterbauelement, wie beispielsweise ein Bipolartransistor mit isolierter Gateelektrode (IGBT) von einer Primärsteuerung, der sogenannten Gateeinheit, angesteuert, indem beispielsweise die Gateeinheit die Steuerspannung des Gates des IGBT einstellt. Die Primärsteuerung bzw. die Gateeinheit wird wiederum von einer Sekundärsteuerung mit Strom versorgt.

Da die Sekundärsteuerung oder die sogenannte obere Steuerung sich in der Regel auf dem Neutralpotential des Halbleitersystems und die Primärsteuerung bzw. die Gateeinheit als die Leistungshalbleitersteuerung sich in der Regel auf dem Potential des Halbleiterbauelements befindet, kann es jedoch notwendig sein, die Primärsteuerung und die Sekundärsteuerung voneinander elektrisch zu isolieren bzw. galvanisch zu trennen. So kann die Stromleitung von der Sekundärsteuerung zur Primärsteuerung eine galvanische Entkopplung in der Form eines Transformators enthalten.

Im Normalbetrieb des Systems wird ein bipolarer Strom von der Sekundärsteuerung an den Transformator geliefert, der den bipolaren Strom über eine galvanische Isolierung an die Primärsteuerung überträgt. Der bipolare Strom wird auf der Seite der Primärsteuerung gleichgerichtet und die Steuerlogik der Primärsteuerung wird mit dem gleichgerichteten Signal versorgt. Auf der Seite der oberen Steuerung bzw. der Sekundärsteuerung wird das bipolare Signal in der Regel durch zwei Antriebe ("driver") oder Schalter erzeugt, von denen der eine invertiert und der andere nicht invertiert ist. Die Stromversorgung dieser Schalter kann durch einen Nebenschlussstromkreis überwacht werden.

Aus Gründen der galvanischen Isolierung werden darüber hinaus häufig faseroptische Schnittstellen dazu verwendet, um Fehlfunktionen von der Primärsteuerung in Richtung der Sekundärsteuerung anzuzeigen, wie beispielsweise eine Sättigungserfassung des IGBTs.

### Darstellung der Erfindung

Die Aufgabe der Erfindung ist es, ein einfach aufgebautes Halbleitersystem mit galvanisch entkoppelter Steuerung bereitzustellen.

Diese Aufgabe wird durch den Gegenstand der unabhängigen Ansprüche gelöst. Weitere Ausführungsformen der Erfindung ergeben sich aus den abhängigen Ansprüchen.

Ein erster Aspekt der Erfindung betrifft eine Primärsteuerung für ein Halbleiterbauelement.

Gemäß einer Ausführungsform der Erfindung umfasst die Primärsteuerung eine Steuerlogik zum Schalten des Halbleiterbauelements und eine Stromleitung zur Energieversorgung der Steuerlogik. Die Steuerlogik ist über die Stromleitung von einer Sekundärsteuerung des Halbleiterbauelements mit Strom versorgbar, wobei die Stromleitung von der Sekundärsteuerung galvanisch entkoppelbar ist, und wobei die Steuerlogik dazu ausgeführt ist, ein Rückmeldesignal über die Stromleitung an die Sekundärsteuerung zu senden.

Eine Rückmeldung, beispielsweise über eine Fehlfunktion des Halbleiterbauelements, wird über die gleiche Leitung übertragen, die zur Energieversorgung der Primärsteuerung dient. Eine vorhandene galvanische Entkopplung der Leitung wird auch zur galvanischen Entkopplung der Signalübertragung verwendet. Zur Rückübertragung von Signalen ist keine faseroptische Verbindung notwendig, wobei nicht ausgeschlossen werden soll, dass nicht weitere faseroptische Verbindungen zur Übertragung von anderen Signalen bei der hier beschriebenen Steuerung vorhanden sein können. Durch den Verzicht auf faseroptische Verbindungen kann der Verkabelungsaufwand und die Anzahl der Kabel vermindert werden.

Das Halbleiterbauelement kann ein Hochleistungshalbleiterbauelement umfassen, das dazu ausgeführt ist, Ströme über 100 A und/oder 300 V zu verarbeiten bzw. zu schalten. Beispielsweise könnte das Halbleiterbauelement ein IGBT, ein MOSFET, ein Thyristor oder eine Diode sein.

Die Steuerlogik zum Schalten des Halbleiterbauelements kann beispielsweise eine integrierte Schaltung sein oder auch eine oder mehrere integrierte Schaltungen umfassen, die beispielsweise auf einer Platine innerhalb der Primärsteuerung angeordnet sind. Im Falle eines Transistors oder Thyristors als Halbleiterbauelement kann die Steuerlogik dazu ausgeführt sein, den Transistor bzw. den Thyristor zu schalten, beispielsweise durch Steuerung der Gatespannung.

Unter einer Stromleitung ist eine allgemeine Stromzuführung zu verstehen, die zum Beispiel eine drahtgebundene Stromleitung oder mehrere drahtgebundene Stromleitungen umfassen kann und in der auch galvanische Isolationselemente zur galvanischen Entkopplung der Stromleitung von der Primärsteuerung zur Sekundärsteuerung enthalten sein können. Eine Stromleitung kann jegliche Vorrichtung sein, die zum Übertragen von elektrischer Energie ausgeführt ist.

Eine galvanische Entkopplung der Primärsteuerung von der Sekundärsteuerung kann dazu ausgeführt sein, dass Strom von der Sekundärsteuerung zur Primärsteuerung übertragen werden kann und die Primärsteuerung und die Sekundärsteuerung sich auf unterschiedlichen elektrischen Potentialen befinden.

Gemäß einer Ausführungsform der Erfindung umfasst die Primärsteuerung ein Lastelement, das mit der Stromleitung verbunden ist, wobei das Lastelement dazu ausgeführt ist, eine elektrische Last auf der Stromleitung zu erzeugen, wobei die elektrische Last des Lastelements einstellbar ist, wobei die Steuerlogik dazu ausgeführt ist, das Rückmeldesignal durch Veränderung der elektrischen Last zu erzeugen.

Mit anderen Worten ist die Primärsteuerung dazu ausgeführt, eine Last auf der Stromleitung dynamisch zu ändern, wobei die Sekundärsteuerung diese Laständerung als Rückmeldesignal interpretieren kann.

Gemäß einer Ausführungsform der Erfindung umfasst das Lastelement einen Widerstand. Dieser Widerstand kann zum Beispiel ein einstellbarer Widerstand sein, der von der Steuerlogik angesteuert werden kann. Beispielsweise könnte die Steuerlogik den einstellbaren Widerstand des Lastelements für eine vordefinierte Zeit derart stark vermindern, dass eine derart hohe Last auf der Stromleitung erzeugt wird, so dass diese von der Sekundärsteuerung als Rückmeldesignal interpretieren werden kann.

Gemäß einer Ausführungsform der Erfindung umfasst das Lastelement einen durch die Steuerlogik steuerbaren Schalter, mit dem ein Stromschluss durch den Widerstand unterbrochen werden kann. In diesem Fall könnte die Steuerlogik zum Erzeugen der Last den Schalter für eine vordefinierte Zeit schließen, so dass Strom durch den Widerstand fließen kann, der eine Last auf der Stromleitung erzeugt.

Gemäß einer Ausführungsform der Erfindung kann die Steuerlogik zum Erzeugen von unterschiedlichen Rückmeldesignalen die elektrische Last modulieren. Im einfachsten Fall ist vorstellbar, dass die Steuerlogik lediglich eine Sorte von Signalen erzeugt, beispielsweise einzelne Lastpulse, die von der Sekundärsteuerung als einzige Rückmeldung interpretiert werden können, nämlich dass eine Fehlfunktion im Bereich der Primärsteuerung oder des daran angeschlossenen Halbleiterbauelements vorliegt. Andererseits ist es aber auch möglich, dass die Steuerlogik unterschiedlich modulierte Rückmeldesignale, beispielsweise über die Anzahl von Pulsen, über die Frequenz oder Amplituden der Pulse oder über Phasenmodulation erzeugt. Auf diese Weise ist eine umfassende Nachrichtenübermittlung von der Primärsteuerung zur Sekundärsteuerung möglich. Mit verschiedenen unterschiedlichen dynamischen Datenpaketen kann die Informationsmenge, die von der Primärsteuerung zur Sekundärsteuerung gesendet werden kann, erhöht werden.

Gemäß einer Ausführungsform der Erfindung ist die Steuerlogik dazu ausgeführt, eine Fehlfunktion des Halbleiterbauelements zu erfassen. Beispielsweise ist die Steuerlogik mit weiteren Sensoren am Halbleiterbauelement verbunden, über die die Steuerlogik wichtige Betriebsparameter des Halbleiterbauelements, wie zum Beispiel den Eingangsstrom und den Ausgangsstrom oder die verschiedenen Spannungen am Halbleiterbauelement erfassen kann.

Gemäß einer Ausführungsform der Erfindung ist die Steuerlogik dazu ausgeführt, in Reaktion auf die Fehlfunktion das Rückmeldesignal zu senden. Beispielsweise könnte das Rückmeldesignal immer dann abgesetzt werden, wenn die Steuerlogik eine Entsättigung des Leistungshalbleiters erfasst hat.

Gemäß einer Ausführungsform der Erfindung umfasst die Primärsteuerung einen Transformator, wobei die galvanische Entkopplung durch den Transformator erfolgt. Der Transformator kann zur Energieübertragung und zur galvanischen Entkopplung zwischen die Primärsteuerung und die Sekundärsteuerung an die Stromleitung gekoppelt sein. Dabei kann der Transformator zwei Wicklungen umfassen, die jeweils mit der Sekundärsteuerung bzw. der Primärsteuerung verbunden sind und die voneinander galvanisch isoliert sind. Damit kann eine Rückmeldung von der Primärsteuerung an die Sekundärsteuerung über einen Versorgungstransformator gegeben werden und die Kommunikation zwischen der Primärsteuerung und der Sekundärsteuerung kann mittels eines Transformators zur Energieübertragung stattfinden.

Gemäß einer Ausführungsform der Erfindung umfasst die Primärsteuerung einen Gleichrichter und einen Speicherkondensator. Mit dem Gleichrichter kann ein vom Transformator kommender bipolarer Strom in einen monopolaren Strom umgewandelt werden. Mit dem Speicherkondensator kann der gleichgerichtete eventuell noch relativ wellige Strom geglättet werden. Beispielsweise kann eine zusätzliche Last bzw. das Lastelement dynamisch nach dem Gleichrichter der Primärsteuerung angewendet werden.

Falls die Primärsteuerung eine Rückmeldung an die Sekundärsteuerung senden will, beispielsweise eine Entsättigungserfassung eines Leistungshalbleiters, kann sich das Lastelement zwischen dem Gleichrichter und dem Speicherkondensator auf der Primärsteuerung befinden. Das Lastelement kann den Gleichrichter und deswegen auch den Transformator belasten. Dieser zusätzliche Strom kann auf Seite der Sekundärsteuerung durch Überwachung des Versorgungsstroms erfasst werden, beispielsweise an einem Nebenkreiswiderstand. Beispielsweise könnte im Falle dessen, dass an diesem Nebenstromwiderstand eine Spannung über einem bestimmten Niveau anliegt, dies als Rückmeldesignal der Primäreinheit erfasst werden.

Gemäß einer Ausführungsform der Erfindung umfasst das Halbleiterbauelement einen Hochleistungsschalter. Ein derartiger Hochleistungsschalter kann beispielsweise ein Transistor, wie etwa ein IGBT, oder ein Thyristor sein.

Gemäß einer Ausführungsform der Erfindung umfasst das Halbleiterbauelement einen Bipolartransistor mit isolierter Gateelektrode (IGBT).

Ein weiterer Aspekt der Erfindung betrifft eine Sekundärsteuerung für ein Halbleiterbauelement.

Gemäß einer Ausführungsform der Erfindung umfasst die Sekundärsteuerung eine Stromversorgung mit einer Stromleitung zur Energieversorgung einer Primärsteuerung des Halbleiterbauelements mit Strom, insbesondere einer Primärsteuerung, so wie sie obenstehend und nachstehend beschrieben ist.

Gemäß einer Ausführungsform der Erfindung umfasst die Sekundärsteuerung weiter eine Überwachungseinheit, wobei die Stromleitung von der Primärsteuerung galvanisch entkoppelbar ist, wobei die Überwachungseinheit dazu ausgeführt ist, ein Rückmeldesignal der Primärsteuerung über die Stromleitung zu empfangen.

Gemäß einer Ausführungsform der Erfindung ist die Überwachungseinheit der Sekundärsteuerung dazu ausgeführt, eine Laständerung auf der Stromleitung als das Rückmeldesignal zu erfassen.

Laständerungen auf der Stromleitung können bis zu der Grenze dynamisch verwendet werden, bis zu der eine gespeicherte Energie in der Primäreinheit sichergestellt werden kann.

Als weitere Anwendung kann eine derartige Sekundärsteuerung bzw. kann der Nebenstromkreis der Sekundärsteuerung einen Kurzschluss in der Primäreinheit anzeigen oder erfassen, falls der Strom statisch über der eben genannten Grenze liegt. Zusätzlich besteht damit die Möglichkeit, einen Kurzschluss in der Primärsteuerung durch die Sekundärsteuerung zu erfassen.

Ein weiterer Aspekt der Erfindung betrifft eine Sekundärsteuerung für ein Halbleiterbauelement, die eine Stromversorgung mit einer Stromleitung zur Energieversorgung einer Primärsteuerung des Halbleiterbauelements mit Strom, insbesondere einer Primärsteuerung, so wie sie obenstehend und nachstehend beschrieben ist, und eine Überwachungseinheit umfasst, wobei die Überwachungseinheit dazu ausgeführt ist, eine Laständerung auf der Stromleitung als das Rückmeldesignal zu erfassen, insbesondere auch ein Kurzschluss in der Primäreinheit.

Gemäß einer Ausführungsform der Erfindung ist die Überwachungseinheit dazu ausgeführt, das Rückmeldesignal durch Vergleich einer elektrischen Last auf der Stromleitung mit einem Schwellwert zu ermitteln.

Gemäß einer Ausführungsform der Erfindung umfasst die Sekundärsteuerung einen Wechselstromerzeuger zur Erzeugung eines Wechselstroms in der Stromleitung, eine weitere Steuerlogik zur Steuerung des Wechselstromerzeugers, wobei die weitere Steuerlogik die Überwachungseinheit umfassen kann, wobei die Stromleitung mit einem Transformator zur galvanischen Entkopplung von der Primärsteuerung koppelbar ist.

Gemäß einer Ausführungsform der Erfindung umfasst die Überwachungseinheit eine Messeinheit zum Erfassen der aktuellen Stromstärke in der Stromleitung. Durch das Erfassen der aktuellen Stromstärke in der Stromleitung kann darauf zurückgeschlossen werden, wie viel Strom die Primäreinheit aktuell verbraucht bzw. wie groß die Last auf der Stromleitung durch die Primäreinheit ist. Damit kann durch das Erfassen der aktuellen Stromstärke, die aktuelle Last auf der Stromleitung und daraus das Rückmeldesignal abgeleitet werden.

Ein weiterer Aspekt der Erfindung betrifft eine Steuerung für ein Halbleiterbauelement.

Gemäß einer Ausführungsform der Erfindung umfasst die Steuerung eine Primärsteuerung, so wie sie obenstehend und nachstehend beschrieben ist.

Gemäß einer Ausführungsform der Erfindung umfasst die Steuerung eine Sekundärsteuerung, so wie sie obenstehend und nachstehend beschrieben ist.

Gemäß einer Ausführungsform der Erfindung umfasst die Steuerung eine Stromleitung mit einer galvanischen Entkopplung zum galvanischen Entkoppeln der Primärsteuerung von der Sekundärsteuerung. Die Steuerung für ein Halbleiterbauelement ist dazu ausgeführt, ein Rückmeldesignal von der Primärsteuerung zur Sekundärsteuerung zu übertragen, ohne dass neben der Stromleitung zur Energieversorgung der Primärsteuerung weitere Leitungen, beispielsweise faseroptische Leitungen, notwendig sind. Auf diese Weise kann in besonders einfacher Form eine galvanische Entkopplung der Primärsteuerung von der Sekundärsteuerung seitens der Signalübertragung erreicht werden.

Ein weiterer Aspekt der Erfindung ist eine Verwendung einer galvanisch entkoppelten Stromleitung zwischen einer Primärsteuerung eines Halbleiterbauelements und einer Sekundärsteuerung zur Stromversorgung der Primärsteuerung als eine Signalleitung.

Ein weiterer Aspekt der Erfindung betrifft ein Verfahren zum Steuern eines Halbleiterbauelements.

Gemäß einer Ausführungsform der Erfindung umfasst das Verfahren die folgenden Schritte: Versorgen einer Primärsteuerung des Halbleiterbauelements mit Strom von einer Sekundärsteuerung über eine galvanisch entkoppelte Stromleitung; Empfangen eines Rückmeldesignals von der Primärsteuerung durch die Sekundärsteuerung über die Stromleitung.

Gemäß einer Ausführungsform der Erfindung umfasst das Verfahren den Schritt von: Senden eines Rückmeldesignals über die Stromleitung von der Primärsteuerung an die Sekundärsteuerung.

Gemäß einer Ausführungsform der Erfindung umfasst das Verfahren den Schritt von: Detektieren einer Fehlfunktion des Halbleiterbauelements durch die Primärsteuerung.

Gemäß einer Ausführungsform der Erfindung umfasst das Verfahren den Schritt von: Detektieren des Rückmeldesignals oder einer Rückmeldung der Primärsteuerung durch die Sekundärsteuerung, beispielsweise Detektieren eines Kurzschlusses in der Primärsteuerung.

Gemäß einer Ausführungsform der Erfindung umfasst das Verfahren den Schritt von: Ändern einer elektrischen Last auf der Stromleitung zum Erzeugen des Rückmeldesignals.

Gemäß einer Ausführungsform der Erfindung umfasst das Verfahren den Schritt von: Überwachen des Versorgungsstroms der Primärsteuerung durch die Sekundärsteuerung zum Erfassen einer Rückmeldung der Primärsteuerung.

Gemäß einer Ausführungsform der Erfindung umfasst das Verfahren den Schritt von: Überwachen des Versorgungsstroms der Primärsteuerung durch die Sekundärsteuerung zum Erfassen eines Kurzschlusses in der Primärsteuerung.

Im Folgenden werden Ausführungsbeispiele der Erfindung mit Bezug auf die beiliegenden Figuren detailliert beschrieben.

### Kurze Beschreibung der Zeichnungen

Fig. 1 zeigt eine Steuerung mit einer faseroptischen Signalübertragung.
Fig. 2 zeigt eine Steuerung gemäß einem Ausführungsbeispiel der Erfindung.
Fig. 3 zeigt eine Steuerung gemäß einem Ausführungsbeispiel der Erfindung.
Fig. 4 zeigt ein Flussdiagramm für ein Verfahren zum Steuern eines Halbleiterbauelements gemäß einem Ausführungsbeispiel der Erfindung.
Fig. 5 zeigt ein Diagramm mit zeitlichen Verläufen verschiedener Ströme, Spannungen und Signale gemäß einem Ausführungsbeispiel der Erfindung.
Fig. 6 zeigt ein Diagramm mit zeitlichen Verläufen verschiedener Ströme, Spannungen und Signale gemäß einem Ausführungsbeispiel der Erfindung.

Die in den Figuren verwendeten Bezugszeichen und ihre Bedeutung sind in zusammenfassender Form in der Liste der der Bezugszeichen aufgeführt. Grundsätzlich sind identische oder ähnliche Teile mit den gleichen Bezugszeichen versehen.

### Wege zur Ausführung der Erfindung

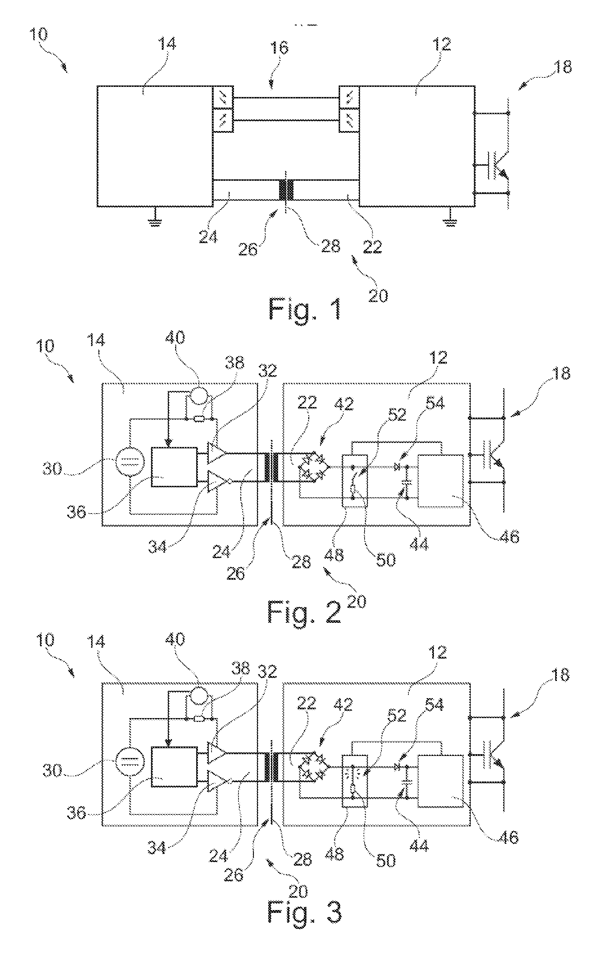

Fig. 1 zeigt schematisch eine Steuerung 10 mit einer Primärsteuerung 12 und einer Sekundärsteuerung 14. Die Primärsteuerung 12 und die Sekundärsteuerung 14 sind über eine Mehrzahl von faseroptischen Verbindungen 16 miteinander verbunden. Des Weiteren ist die Primärsteuerung 12 dazu ausgeführt, ein Halbleiterbauelement 18, beispielsweise einen IGBT 18, und insbesondere dessen Gate, anzusteuern. Zur Stromversorgung ist die Primärsteuerung 12 über eine Stromleitung 20 mit der Sekundärsteuerung 14 verbunden. Die Stromleitung 20 umfasst einen ersten Stromkreis 22 und einen zweiten Stromkreis 24. Der erste Stromkreis 22 ist mit der Primärsteuerung 12 und einer Wicklung eines Transformators 28 verbunden. Der zweite Stromkreis 24 ist mit der Sekundärsteuerung 14 und einer weiteren Wicklung des Transformators 26 verbunden. Die beiden Wicklungen des Transformators sind zur Energieübertragung miteinander elektromagnetisch gekoppelt aber über eine galvanische Entkopplung 28 voneinander isoliert.

Fig. 2 zeigt schematisch eine weitere Ausführungsform einer Steuerung 10. Die Sekundärsteuerung 14 weist eine Spannungsquelle 30 auf, die einen Verstärker 32 mit nicht invertiertem Ausgang und einen Verstärker 34 mit invertiertem Ausgang speist. Eine Steuerlogik 36 der Steuerung 14 ist mit den beiden Verstärkern 32 und 34 gekoppelt und derart ausgeführt, dass die beiden Verstärker 32 und 34 die Spannungsquelle 30 mit dem zweiten Stromkreis 24 derart verbinden, dass ein bipolarer Stromfluss durch den zweiten Stromkreis 24 erzeugt wird, der gleichzeitig auch damit durch eine Wicklung des Transformators 28 fließt.

Die Steuerlogik 36 der Sekundärsteuerung 14 ist weiter zur Überwachung des Stromflusses in Stromkreis 24 ausgeführt. Dazu befindet sich ein Widerstand 38 in der Stromleitung zwischen dem ersten Verstärker 32 und der Stromquelle 30. Diesem Widerstand 38 ist ein Messgerät 40 parallel geschaltet, dessen Messsignal von der Steuerlogik 36 ausgewertet werden kann.

Die Primärsteuerung 12 umfasst einen Gleichrichter 42, der mit dem ersten Stromkreis 22 verbunden ist und der das vom Transformator 28 übertragene bipolare Signal gleichrichtet. Der Gleichrichter 42 ist über einen Speicherkondensator 44 mit einer Steuerlogik 46 der Primärsteuerung 12 verbunden. Der vom Gleichrichter stammende gleichgerichtete monopolare Strom wird vom Speicherkondensator 44 geglättet und der Steuerlogik 46 zur Energieversorgung zugeführt.

Die Primärsteuerung 12 umfasst zwischengeschaltet zwischen dem Gleichrichter 42 und dem Speicherkondensator 44 eine variable Last 48 bzw. ein Lastelement 48, die bzw. das einen Widerstand 50 und einen mit dem Widerstand 50 in Reihe geschalteten Schalter 52 umfasst, die beide wiederum parallel zum Speicherkondensator 44 geschaltet sind. Die variable Last 48 und insbesondere der Schalter 52 können von der Steuerlogik 46 angesteuert werden, bzw. der Schalter 52 von der Steuerlogik 46 geöffnet und geschlossen werden.

Die Fig. 3 zeigt schematisch die Ausführungsform der Fig. 2 mit geschlossenem Schalter 52.

Hat beispielsweise die Steuerlogik 46 der Primärsteuerung 12 erfasst, dass eine Entsättigung des IGBTs 18 eingetreten ist, schließt sie den Schalter 52 und öffnet ihn nach einer vordefinierter Zeitperiode wieder. Durch den geschlossenen Schalter 52 ist ein Stromfluss durch den Widerstand 50 parallel zum Speicherkondensator 44 möglich, der eine Last auf dem Gleichrichter 42, den Transformator 28 und somit auch im zweiten Stromkreis 24 erzeugt. Eine Diode 54 verhindert, dass Strom aus dem Speicherkondensator 44 über die variable Last 48 abfließen kann. Somit kann der Speicherkondensator 44 eine begrenzte Zeit, während der Schalter 52 geschlossen ist, noch die Steuerlogik 46 mit Energie versorgen.

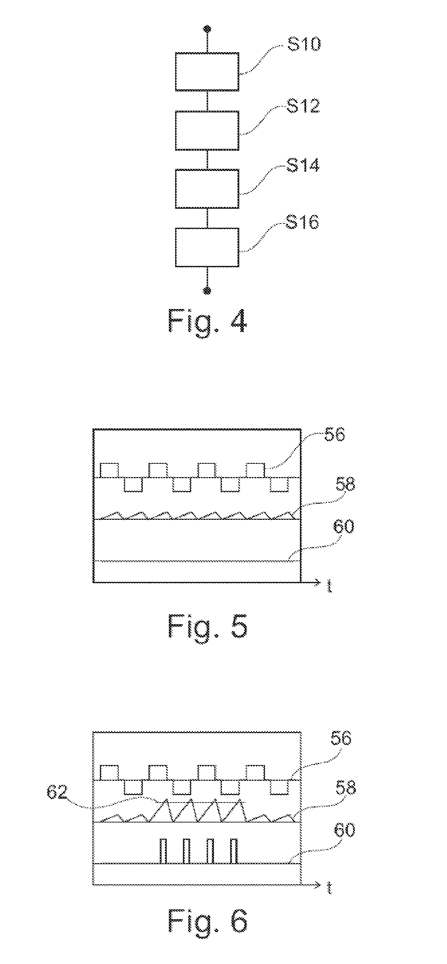

Fig. 4 zeigt ein Flussdiagramm eines Verfahrens, das von der Steuerung 10 durchgeführt werden kann.

Während eines Schritts S10 erzeugt die Sekundärsteuerung 14 aus dem Strom der Gleichspannungsquelle 30 mittels der beiden Verstärker 32 und 34, die durch die Steuerlogik 36 alternierend angesteuert werden, einen bipolaren Strom bzw. ein bipolares Signal im zweiten Stromkreis 24, der vom Transformator 28 galvanisch entkoppelt in den ersten Stromkreis 22 übertragen wird. Der bipolare Strom wird vom Gleichrichter 42 gleichgerichtet und mittels des Speicherkondensators 44 geglättet und dient zur Stromversorgung der Steuerlogik 46 der Primärsteuerung 12.

In einem Schritt S12 erfasst die Steuerlogik 46 eine Fehlfunktion im Halbleiterbauelement 18, beispielsweise stellt sie eine Entsättigung des IGBTs 18 fest.

In einem Schritt S14, in Reaktion auf das Erfassen der Fehlfunktion, schließt die Steuerlogik 46 den Schalter 52 der variablen Last 48 für eine kurze Zeit und erzeugt so einen Stromfluss durch den Widerstand 50. Dadurch entsteht ein Stromfluss parallel zum Speicherkondensator 44, der den Stromkreis 22 schließt. Ein entsprechender Stromfluss entsteht im zweiten Stromkreis 24.

In einem Schritt S16 erfasst die Steuerlogik 36 der Sekundärsteuerung 40 mittels des Messgerätes 40 den Stromfluss, der durch die variable Last 48 erzeugt wird. Durch den Vergleich mit einem Schwellwert stellt die Steuerlogik 36 fest, dass die variable Last 48 geschlossen wurde und die Primärsteuerung 12 damit ein Rücksendesignal abgegeben hat.

Alternativ dazu kann die Sekundärsteuerung 14 auch einen Kurzschluss in der Primärsteuerung 12 erfassen. Beispielsweise kann das Schließen der variablen Last 48 für eine vordefinierte Zeitperiode erfolgen. Ist eine von der Steuerlogik 36 gemessene Last über dem Schwellwert länger als diese Zeitperiode vorhanden, kann die Steuerlogik 36 darauf zurückschließen, dass ein Kurzschluss in der Primärsteuerung 12 vorhanden sein muss.

Fig. 5 zeigt ein Diagramm mit dem zeitlichen Verlauf verschiedener Signale und Ströme innerhalb der Steuerung 10. Der beispielsweise am Transformator vorliegende bipolare Spannungsverlauf ist mit dem Bezugszeichen 56 bezeichnet. Der Verlauf der Zeit ist in der Fig. 5 nach rechts aufgetragen, die Stärke eines Signals nach oben. Wie aus der Fig. 5 entnommen werden kann, weist der bipolare Spannungsverlauf jeweils eine Periode über seinen Nullpunkt und darauffolgend alternierend eine Periode unterhalb seines Mittelwerts auf.

Die Fig. 5 zeigt den Verlauf des Versorgungsstroms durch den Widerstand 38 während des Normalbetriebs der Steuerung 10, bei dem die Primärsteuerung 12 kein Rückmeldungssignal abgibt. Daher wird auch kein Rückmeldesignal 60 erfasst.

In Fig. 6 ist ein der Fig. 5 entsprechendes Diagramm mit dem gleichen bipolaren Transformatorsignal 56 dargestellt. Fig. 6 stellt jedoch dar, dass die Steuerlogik 46 vier im gleichen Abstand zeitlich aufeinander folgende Male ein Rückmeldungssignal abgegeben hat, in dem sie die variable Last 48 vier Mal aktiviert hat. Wie aus der Fig. 6 erkennbar ist, hat der Stromfluss im Versorgungsstromkreis mit dem Widerstand 38 vier Mal einen Schwellwert 62 überschritten. Jedes Mal, wenn der Stromfluss 58 den Schwellwert 62 überschritten hat, hat dies die Steuerlogik 36 bzw. Überwachungslogik 36 der Sekundärsteuerung 14 dies als Rückmeldungssignal 60 der Primärsteuerung 12 interpretiert.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### Bezugszeichenliste

- 10: Steuerung
- 12: Primärsteuerung
- 14: Sekundärsteuerung
- 16: Faseroptik
- 18: Halbleiterbauelement
- 20: Stromleitung
- 22: Stromkreis
- 24: Stromkreis
- 26: Transformator
- 28: galvanische Entkopplung
- 30: Spannungsquelle
- 32: Verstärker
- 34: Verstärker
- 36: Steuerlogik
- 38: Widerstand
- 40: Messgerät
- 42: Gleichrichter
- 44: Speicherkondensator
- 46: Steuerlogik
- 48: variable Last
- 50: Widerstand
- 52: Schalter
- 54: Diode
- 56: bipolarer Spannungsverlauf
- 58: Laststrom
- 60: Rückmeldesignal
- 62: Schwellwert

## Patentansprüche

1. Primärsteuerung (12) für ein Halbleiterbauelement (18), die Primärsteuerung (12) umfassend:
eine Steuerlogik (46) zum Schalten des Halbleiterbauelements (18),
eine Stromleitung (20) zur Energieversorgung der Steuerlogik,
wobei die Steuerlogik (46) über die Stromleitung (20) von einer Sekundärsteuerung (14) des Halbleiterbauelements (18) mit Strom versorgbar ist,
wobei die Stromleitung (20) von der Sekundärsteuerung (14) galvanisch entkoppelbar ist,
wobei die Steuerlogik (46) dazu ausgeführt ist, ein Rückmeldesignal über die Stromleitung (20) an die Sekundärsteuerung (14) zu senden.

2. Primärsteuerung (12) nach Anspruch 1, weiter umfassend:
ein Lastelement (48), das mit der Stromleitung (20) verbunden ist,
wobei das Lastelement (48) dazu ausgeführt ist, eine elektrische Last auf der Stromleitung (20) zu erzeugen,
wobei die elektrische Last des Lastelements (48) einstellbar ist,
wobei die Steuerlogik (46) dazu ausgeführt ist, das Rückmeldesignal durch Veränderung der elektrischen Last zu erzeugen.

3. Primärsteuerung (12) nach Anspruch 1 oder 2,
wobei das Lastelement (48) einen Widerstand (50) umfasst.

4. Primärsteuerung (12) nach Anspruch 3,
wobei das Lastelement (48) einen durch die Steuerlogik (46) steuerbaren Schalter (52) umfasst, mit dem ein Stromfluss durch den Widerstand (50) unterbrochen werden kann.

5. Primärsteuerung (12) nach einem der Ansprüche 2 bis 4,
wobei die Steuerlogik (46) zum Erzeugen von unterschiedlichen Rückmeldesignalen die elektrische Last modulieren kann.

6. Primärsteuerung (12) nach einem der vorhergehenden Ansprüche,
wobei die Steuerlogik (46) dazu ausgeführt ist, eine Fehlfunktion des Halbleiterbauelements (18) zu erfassen,
wobei die Steuerlogik (46) dazu ausgeführt ist, in Reaktion auf die Fehlfunktion das Rückmeldesignal zu senden.

7. Primärsteuerung (12) nach einem der vorhergehenden Ansprüche, weiter umfassend:
einen Transformator (26),
wobei die galvanische Entkopplung (28) durch den Transformator (26) erfolgt.

8. Primärsteuerung (12) nach einem der vorhergehenden Ansprüche,
wobei das Halbleiterbauelement (18) einen Hochleistungsschalter umfasst.

9. Sekundärsteuerung (14) für ein Halbleiterbauelement (18), die Sekundärsteuerung (14) umfassend:
eine Stromversorgung (30) mit einer Stromleitung (20) zur Energieversorgung einer Primärsteuerung (12) des Halbleiterbauelements (18) mit Strom,
eine Überwachungseinheit (36),
wobei die Stromleitung (20) von der Primärsteuerung (12) galvanisch entkoppelbar ist,
wobei die Überwachungseinheit (36) dazu ausgeführt ist, ein Rückmeldesignal der Primärsteuerung (12) über die Stromleitung (20) zu empfangen.

10. Sekundärsteuerung (14) nach Anspruch 9,
wobei die Überwachungseinheit (36) dazu ausgeführt ist, eine Laständerung auf der Stromleitung (20) als das Rückmeldesignal zu erfassen.

11. Sekundärsteuerung nach Anspruch 9 oder 10,
wobei die Überwachungseinheit (36) dazu ausgeführt ist, das Rückmeldesignal durch Vergleich einer elektrischen Last auf der Stromleitung (20) mit einem Schwellwert (62) zu ermitteln.

12. Steuerung (10) für ein Halbleiterbauelement, umfassend:
eine Primärsteuerung (12) nach einem der Ansprüche 1 bis 8,
eine Sekundärsteuerung (14) nach einem der Ansprüche 9 bis 11,
eine Stromleitung (20) mit einer galvanischen Entkopplung (28) zum galvanischen Entkoppeln der Primärsteuerung (12) von der Sekundärsteuerung (14).

13. Verwendung einer galvanisch entkoppelten Stromleitung (20) zwischen einer Primärsteuerung (12) eines Halbleiterbauelements (18) und einer Sekundärsteuerung (14) zur Stromversorgung der Primärsteuerung (12) als eine Signalleitung (20).

14. Verfahren zum Steuern eines Halbleiterbauelements (18), das Verfahren umfassend die Schritte:
Versorgen einer Primärsteuerung (12) des Halbleiterbauelements (18) mit Strom von einer Sekundärsteuerung (14) über eine galvanisch entkoppelte Stromleitung (20);
Empfangen eines Rückmeldesignals von der Primärsteuerung (12) durch die Sekundärsteuerung (14) über die Stromleitung (20).

15. Verfahren nach Anspruch 14, weiter umfassend den Schritt:
Ändern einer elektrischen Last auf der Stromleitung (20) zum Erzeugen des Rückmeldesignals.
